# DEMANDE DE BREVET EUROPEEN

(11) **EP 4 576 985 A1**
(43) Date de publication de la demande: **25.06.2025**
(21) Numéro de dépôt: 24222249.5
(22) Date de dépôt: 20.12.2024
(51) Int. Cl.: H10D 1/68, H10N 70/00, H10N 70/20, H10B 53/30

(54) **DISPOSITIF DE STOCKAGE FERROELECTRIQUE ET PROCEDE DE FABRICATION D'UN TEL DISPOSITIF**

(30) Priorité: 21.12.2023 FR 2314855
(71) Demandeur: Commissariat à l'Energie Atomique et aux Energies Alternatives, 75015 Paris (FR)
(72) Inventeur: BORREL, Julien, 38054 GRENOBLE CEDEX 09 (FR); BARBOT, Justine, 38054 GRENOBLE CEDEX 09 (FR); COIGNUS, Jean, 38054 GRENOBLE CEDEX 09 (FR); GRENOUILLET, Laurent, 38054 GRENOBLE CEDEX 09 (FR)
(74) Mandataire: Cabinet Camus Lebkiri

(57) **Abrégé**

L'invention concerne un dispositif (1) de stockage ferroélectrique comprenant une première couche (2), une deuxième couche (7) et une couche de matériau ferroélectrique (5) qui s'étend entre la première couche (2) et la deuxième couche (7), la couche de matériau ferroélectrique (5) comprenant une première partie (5A) présentant une première épaisseur (e₁) et une deuxième partie (6) présentant une deuxième épaisseur (e₂), la première épaisseur (e₁) et la deuxième épaisseur (e₂) étant distinctes.

## Description

### DOMAINE TECHNIQUE

La présente invention concerne de manière générale le domaine de la micro-électronique. Elle concerne plus particulièrement le domaine des mémoires non volatiles.

En particulier, l'invention concerne un dispositif de stockage ferroélectrique. Elle concerne également un procédé de fabrication d'un tel dispositif de stockage ferroélectrique.

### ÉTAT DE LA TECHNIQUE

Les mémoires ferroélectriques de type FeRAM (pour « *Ferroelectric Random Access Memory* » selon l'acronyme d'origine anglo-saxonne couramment utilisé) ont pour principale qualité d'être non volatiles, c'est-à-dire de conserver l'information stockée même quand la tension est coupée. Elles présentent également les avantages de consommer peu d'énergie et d'avoir des temps d'écriture et de lecture faibles par rapport à d'autres types de mémoires non volatiles comme les mémoires FLASH.

Les mémoires ferroélectriques de type FeRAM se présentent généralement sous la forme d'un empilement dans lequel une couche de matériau ferroélectrique est positionnée entre deux électrodes métalliques. Les mémoires ferroélectriques sont des mémoires de type capacitif présentant deux états de polarisation rémanente +Pr et - Pr. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FeRAM, par l'application d'une différence de potentiels entre les deux électrodes créant un champ électrique d'une valeur supérieure à un champ coercitif positif +Ec, la mémoire ferroélectrique est placée dans un état de polarisation rémanente haute +Pr et par l'application d'une différence de potentiels créant un champ électrique d'une valeur inférieure au champ coercitif négatif -Ec, la mémoire ferroélectrique est placée dans un état de polarisation rémanente basse -Pr.

L'état de polarisation rémanente haute +Pr correspond alors à l'état logique binaire '0' et l'état de polarisation rémanente basse -Pr à l'état logique binaire '1', ce qui permet le stockage de l'information.

Par ailleurs, lorsque l'application de la différence de potentiels entre les deux électrodes métalliques est arrêtée, l'état de polarisation rémanente demeure : ceci explique alors le caractère non volatil des mémoires ferroélectriques.

Pour la lecture, il est supposé que la mémoire est dans un état donné et une tension est appliquée. Cette tension est par exemple positive, supérieure à la tension créant un champ électrique d'une valeur supérieure au champ coercitif positif +Ec. Ainsi, si la mémoire était déjà dans l'état de polarisation rémanente haute +Pr, cet état de polarisation est inchangé et aucun pic de courant n'est observé (ou un très faible pic de courant peut être observé). A l'inverse, si la mémoire était dans l'état de polarisation rémanente basse -Pr, un pic de courant beaucoup plus important est observé.

La conséquence de cette opération de lecture est qu'elle est destructrice de l'état de polarisation.

Des mémoires ferroélectriques à jonction tunnel (ou de type FTJ pour *« Ferroelectric Tunnel Junction »* selon l'acronyme d'origine anglo-saxonne couramment utilisé) sont également connues. Les mémoires ferroélectriques de type FTJ se présentent généralement sous la forme d'un empilement dans lequel une couche de matériau ferroélectrique est positionnée entre deux électrodes métalliques. Les mémoires ferroélectriques de type FTJ sont des mémoires de type résistif présentant deux états de polarisation opposés pour la couche de matériau ferroélectrique. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FTJ, les deux états de polarisation correspondent respectivement à deux niveaux de résistance différents : un niveau fortement résistif, correspondant à par exemple à un état de polarisation haute +Pr et un niveau faiblement résistif, correspondant à un état de polarisation basse -Pr. A titre d'exemple, le niveau faiblement résistif présente une résistance électrique environ mille fois inférieure à celle du niveau fortement résistif.

Dans le cas des mémoires ferroélectriques de type FTJ, l'opération de lecture comprend l'application d'une tension de lecture -Vr. La tension de lecture -Vr est par exemple négative et inférieure en valeur absolue à une tension Vc associée au champ coercitif. Cela permet alors d'effectuer une lecture non-destructive par l'intermédiaire de la mesure d'un courant tunnel.

Afin d'augmenter la densité de mémoire, il est connu de mettre en oeuvre un stockage dit « multi-niveaux ». Ce stockage « multi-niveaux » est associé à différents états de polarisation, sur lesquels il va être possible de mémoriser de l'information.

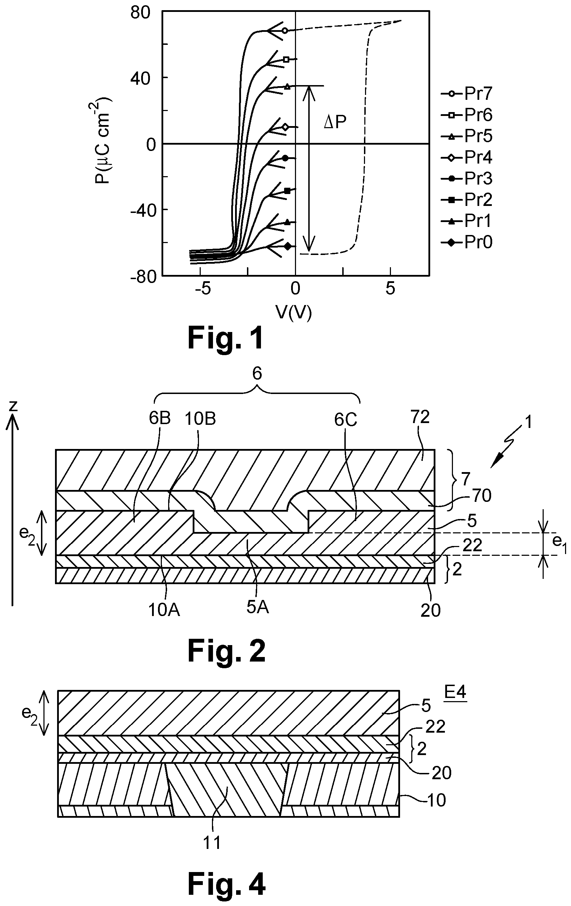

Le document « Multilevel data storage memory using deterministic polarization control. », de Lee, Daesu et al., dans Advanced materials, vol. 24(3), 2012, 402-406, doi:10.1002/adma.201103679 décrit une mémoire ferroélectrique de type FeRAM présentant plusieurs niveaux de stockage. Dans cet exemple, comme cela est représenté sur la figure 1 (représentant l'évolution de la polarisation P en fonction de la tension appliquée V), la mémoire peut être placée dans plusieurs états de polarisation rémanente intermédiaires Pn, Pr₂, Pr₃, Pr₄, Pr₅, Pr₆, Pr₇ (Pr₀ correspondant à l'état 0 de polarisation basse). Il va donc être possible de stocker l'information à différents niveaux. Grâce à ce stockage « multi-niveaux », il est donc possible de coder plusieurs états par mémoire (ici, dans l'exemple, huit états sont codés), alors que dans une cellule standard seulement deux états sont accessibles (les états 0 ou 1 uniquement). Ainsi, l'information contenue dans une mémoire avec un stockage « multi-niveaux » est équivalent à celle contenue dans plusieurs mémoires de type standard.

En pratique, dans cet exemple, pour mettre en oeuvre ce stockage sur les différents niveaux intermédiaires, chaque état de polarisation intermédiaire Pr₁, Pr₂, Pr₃, Pr₄, Pr₅, Pr₆, Pr₇ est associé à un courant correspondant. Ainsi, lors de l'application d'une tension entre les électrodes, un courant ferroélectrique associé est lu. Ce courant permet ensuite d'identifier l'état de polarisation intermédiaire Pr₁, Pr₂, Pr₃, Pr₄, Pr₅, Pr₆, Pr₇ concerné et donc de remonter à l'information stockée initialement dans cet état de polarisation intermédiaire Pr₁, Pr₂, Pr₃, Pr₄, Pr₅, Pr₆, Pr₇ de la mémoire ferroélectrique.

Cependant, certains inconvénients sont observés dans de telles mémoires à haute densité. Il peut par exemple être difficile de distinguer deux états de polarisation intermédiaires qui sont proches. En effet, un recouvrement entre les différents états de polarisation intermédiaires peut être rencontré. Dans un tel cas, l'application d'une tension (entre les électrodes) de cette zone de recouvrement ne permet pas de déduire de manière certaine le courant associé, et donc l'état de polarisation rémanente intermédiaire concerné.

### RÉSUMÉ DE L'INVENTION

La présente invention vise donc à améliorer les dispositifs de stockage ferroélectrique à haute densité en permettant une distinction sans ambiguïté des différents états de polarisation.

L'invention concerne alors un dispositif de stockage ferroélectrique comprenant une première couche, une deuxième couche et une couche de matériau ferroélectrique qui s'étend entre la première couche et la deuxième couche,
la couche de matériau ferroélectrique comprenant une première partie présentant une première épaisseur et une deuxième partie présentant une deuxième épaisseur, la première épaisseur et la deuxième épaisseur étant distinctes.

Ainsi, la couche de matériau ferroélectrique du dispositif de stockage ferroélectrique selon l'invention présente une épaisseur non uniforme. Cette variabilité d'épaisseurs entraîne une non-uniformité dans les propriétés ferroélectriques du dispositif de stockage ferroélectrique. Cette non-uniformité des propriétés permet notamment d'augmenter les différences entre les gammes de tensions à appliquer pour mémoriser les informations dans les différents états de polarisation intermédiaires.

En effet, les différentes épaisseurs impliquent alors, que pour une tension (d'écriture) donnée, le champ électrique est plus grand dans les régions de plus faible épaisseur. En d'autres termes, pour écrire des informations dans un état de polarisation intermédiaire associé à une faible épaisseur, une plus grande tension doit être appliquée. Les différences d'épaisseurs conduisent donc à des différences de tensions à appliquer pour encoder les informations dans les différents états de polarisation intermédiaires.

Les épaisseurs différentes utilisées sont donc associées à différents états de polarisation intermédiaires dans le dispositif de stockage ferroélectrique.

En d'autres termes, grâce à la non-uniformité créée dans la couche de matériau ferroélectrique (due à la variabilité d'épaisseurs), les différences entre les états de polarisation intermédiaires sont créées.

Outre les caractéristiques qui viennent d'être évoquées dans les paragraphes précédents, le dispositif de stockage ferroélectrique selon un aspect de l'invention peut présenter une ou plusieurs caractéristiques complémentaires parmi les suivantes, considérées individuellement ou selon toutes les combinaisons techniquement possibles :
- la première couche présente une épaisseur constante ;
- le dispositif comprend une couche support présentant une cavité, la cavité comprenant une paroi de fond et une paroi latérale, la paroi latérale formant un angle d'inclinaison par rapport à une direction normale à la paroi de fond, la première couche, la deuxième couche et la couche de matériau ferroélectrique étant positionnées dans la cavité ;
- un rapport entre la deuxième épaisseur et la première épaisseur est compris entre 2 et 4 ;
- la première épaisseur est comprise entre 3 et 7 nanomètres et la deuxième épaisseur est comprise entre 12 et 17 nanomètres ;
- la première partie de la couche de matériau ferroélectrique présente une surface d'au moins 15% de la surface totale de la couche de matériau ferroélectrique ;
- la couche de matériau ferroélectrique comprend du dioxyde d'hafnium ou du dioxyde d'hafnium dopé par un élément dopant ou un alliage HfₓZr₁₋ₓO₂, avec 0<x<1 ;
- la première couche comprend un matériau métallique ;
- le matériau métallique compris dans la première couche est choisi parmi du tungstène, du nitrure du titane, du nitrure de tantale ;
- la première couche comprend une première sous-couche et une deuxième sous-couche, la deuxième sous-couche étant disposée sur la première sous-couche ;
- le matériau de la première sous-couche est choisi parmi du nitrure de titane, du nitrure de tantale ou du tungstène ;
- la première couche comprend un matériau semi-conducteur ;
- le matériau semi-conducteur compris dans la première couche est du silicium ;
- le matériau de la deuxième sous-couche est choisi parmi du titane, du tantale ou de l'hafnium ;
- la deuxième couche comprend un matériau métallique ;
- le matériau métallique compris dans la deuxième couche est choisi parmi du tungstène, du nitrure du titane, du nitrure de tantale ;
- la deuxième couche comprend une autre première sous-couche et une autre deuxième sous-couche, l'autre deuxième sous-couche étant disposée sur l'autre première sous-couche ;
- le matériau de l'autre première sous-couche est choisi parmi du titane, du tantale ou de l'hafnium ;
- le matériau de l'autre deuxième sous-couche est choisi parmi du nitrure de titane, du nitrure de tantale ou du tungstène ;
- la deuxième couche comprend un matériau semi-conducteur ;
- le matériau semi-conducteur compris dans la deuxième couche est du silicium ;
- la cavité présente un profil en forme de U, la première couche, la deuxième couche et la couche de matériau ferroélectrique étant positionnées dans la cavité de sorte que la première couche, la deuxième couche et la couche de matériau ferroélectrique présentent un profil de forme similaire à la cavité avec un profil en forme de U ;
- le premier angle d'inclinaison est compris entre 13 et 50 degrés, de préférence entre 15 et 35 degrés ;
- la deuxième partie de la couche de matériau ferroélectrique est positionnée sur la paroi de fond de la cavité avec un profil en forme de U et la première partie de la couche de matériau ferroélectrique est positionnée sur la paroi latérale de la cavité avec un profil en forme de U ;
- la paroi latérale comprend une première portion et une deuxième portion, la première portion formant ledit premier angle d'inclinaison par rapport à la direction normale à la paroi de fond, la deuxième portion formant un deuxième angle d'inclinaison par rapport à la direction normale à la paroi de fond ;
- le deuxième angle d'inclinaison est supérieur audit premier angle d'inclinaison ;
- le deuxième angle d'inclinaison est compris entre 15 et 70 degrés, de préférence entre 20 et 40 degrés ;
- la couche de matériau ferroélectrique comprend une troisième partie présentant une troisième épaisseur, la troisième épaisseur étant distincte de la première épaisseur et de la deuxième épaisseur, la deuxième partie de la couche de matériau ferroélectrique étant positionnée sur la paroi de fond de la cavité, la première partie de la couche de matériau ferroélectrique étant positionnée sur la première portion de la paroi latérale de la cavité et la troisième partie de la couche de matériau ferroélectrique étant positionnée sur la deuxième portion de la paroi latérale de la cavité;
- la surface de contact entre la première couche et la couche de matériau ferroélectrique est parallèle à la surface de contact entre la première couche et la cavité ; et
- la première couche forme une première électrode, la deuxième couche forme une deuxième électrode et la couche de matériau ferroélectrique forme une couche mémoire.

L'invention concerne également un procédé de fabrication d'un dispositif de stockage ferroélectrique comprenant des étapes de :
- dépôt d'une première couche,
- dépôt d'une couche de matériau ferroélectrique, la couche de matériau ferroélectrique comprenant une première partie présentant une première épaisseur et une deuxième partie présentant une deuxième épaisseur, la première épaisseur et la deuxième épaisseur étant distinctes, et
- dépôt d'une deuxième couche, la couche de matériau ferroélectrique s'étendant entre la première couche et la deuxième couche.

Outre les caractéristiques qui viennent d'être évoquées dans les paragraphes précédents, le procédé de fabrication selon un autre aspect de l'invention peut présenter une ou plusieurs caractéristiques complémentaires parmi les suivantes, considérées individuellement ou selon toutes les combinaisons techniquement possibles :
- la première couche présente une épaisseur constante ;
- le dépôt de la première couche est mis en oeuvre par pulvérisation cathodique ou par un dépôt chimique en phase vapeur ;
- le dépôt de la deuxième couche est mis en oeuvre par pulvérisation cathodique ou par un dépôt chimique en phase vapeur ;
- il est prévu, avant l'étape de dépôt de la deuxième couche, une étape de retrait d'une portion de la couche de matériau ferroélectrique, la première partie de la couche de matériau ferroélectrique étant formée au niveau d'une portion restante associée à ladite portion retirée ;
- l'étape de retrait est mise en oeuvre par photolithogravure ;
- le dépôt de la couche de matériau ferroélectrique est mis en oeuvre de manière conforme ;
- le dépôt de la couche de matériau ferroélectrique est mis en oeuvre par une méthode de dépôt par couche atomique ou par dépôt chimique en phase vapeur ;
- il est prévu, avant l'étape de dépôt de la deuxième couche, une étape d'implantation d'un élément dopant dans la couche de matériau ferroélectrique de manière à doper la couche de matériau ferroélectrique par l'élément dopant ;
- il est prévu, après l'étape de dépôt de la deuxième couche, une étape de planarisation de manière à uniformiser la surface de la deuxième couche ;
- il est prévu, avant l'étape de dépôt de la première couche, des étapes de :
   a) fourniture d'une couche support, et
   b) formation d'une cavité dans la couche support, la cavité comprenant une paroi de fond et une paroi latérale, la paroi latérale formant un premier angle d'inclinaison non nul par rapport à une direction normale à la paroi de fond,
      le dépôt de la première couche, de la couche de matériau ferroélectrique et de la deuxième couche étant mis en oeuvre dans la cavité formée,
      la deuxième partie de la couche de matériau ferroélectrique étant positionnée sur la paroi de fond de la cavité et la première partie de la couche de matériau ferroélectrique étant positionnée sur la paroi latérale de la cavité ;
- la paroi latérale de la cavité comprend une première portion et une deuxième portion, la première portion formant ledit premier angle d'inclinaison par rapport à la direction normale à la paroi de fond, la deuxième portion formant un deuxième angle d'inclinaison par rapport à la direction normale à la paroi de fond, une étape de formation de la deuxième portion de la cavité étant prévue,
   la couche de matériau ferroélectrique comprenant une troisième partie présentant une troisième épaisseur, la troisième épaisseur étant distincte de la première épaisseur et de la deuxième épaisseur, la deuxième partie de la couche de matériau ferroélectrique étant positionnée sur la paroi de fond de la cavité, la première partie de la couche de matériau ferroélectrique étant positionnée sur la première portion de la paroi latérale de la cavité et la troisième partie de la couche de matériau ferroélectrique étant positionnée sur la deuxième portion de la paroi latérale de la cavité ;
- le premier angle d'inclinaison est compris entre 13 et 50 degrés, de préférence entre 15 et 35 degrés ;
- la formation de la cavité est mise en oeuvre par une gravure isotrope ;
- la formation de la cavité est mise en oeuvre par gravure chimique humide ;
- la paroi latérale de la cavité comprenant une première portion et une deuxième portion, la première portion formant ledit premier angle d'inclinaison par rapport à la direction normale à la paroi de fond, la deuxième portion formant un deuxième angle d'inclinaison par rapport à la direction normale à la paroi de fond, il est prévu une étape de formation de la deuxième portion de la cavité,
   la couche de matériau ferroélectrique comprenant une troisième partie présentant une troisième épaisseur, la troisième épaisseur étant distincte de la première épaisseur et de la deuxième épaisseur, la première partie de la couche de matériau ferroélectrique étant positionnée sur la paroi de fond de la cavité, la deuxième partie de la couche de matériau ferroélectrique étant positionnée sur la première portion de la paroi latérale de la cavité et la troisième partie de la couche de matériau ferroélectrique étant positionnée sur la deuxième portion de la paroi latérale de la cavité ;
- le dépôt de la couche de matériau ferroélectrique est mis en oeuvre de manière non conforme ;
- la formation de la deuxième portion de la cavité est mise en oeuvre par gravure chimique humide ;
- la surface de contact entre la première couche et la couche de matériau ferroélectrique est parallèle à la surface de contact entre la première couche et la cavité ; et
- le deuxième angle d'inclinaison est supérieur audit premier angle d'inclinaison.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 illustre les différents états de polarisation intermédiaires dans le cas d'une mémoire ferroélectrique de type FeRAM présentant plusieurs niveaux de stockage,
La figure 2 représente, sous forme schématique, un premier exemple d'un dispositif de stockage ferroélectrique conforme à l'invention,
La figure 3 représente, sous forme de logigramme, un exemple du procédé de fabrication du dispositif de stockage ferroélectrique de la figure 2,
La figure 4 illustre l'étape E4 du procédé de fabrication représenté sur la figure 3,
La figure 5 illustre l'étape E6 du procédé de fabrication représenté sur la figure 3,
La figure 6 illustre l'étape E8 du procédé de fabrication représenté sur la figure 3,
La figure 7 illustre l'étape E10 du procédé de fabrication représenté sur la figure 3,
La figure 8 représente, sous forme schématique, un deuxième exemple d'un dispositif de stockage ferroélectrique conforme à l'invention,
La figure 9 représente, sous forme de logigramme, un exemple du procédé de fabrication du dispositif de stockage ferroélectrique de la figure 8,
La figure 10 illustre l'étape E102 du procédé de fabrication représenté sur la figure 9,
La figure 11 illustre l'étape E104 du procédé de fabrication représenté sur la figure 9,
La figure 12 illustre l'étape E106 du procédé de fabrication représenté sur la figure 9,
La figure 13 illustre l'étape E108 du procédé de fabrication représenté sur la figure 9,
La figure 14 représente, sous forme schématique, un troisième exemple d'un dispositif de stockage ferroélectrique conforme à l'invention,
La figure 15 représente, sous forme de logigramme, un exemple du procédé de fabrication du dispositif de stockage ferroélectrique de la figure 14,
La figure 16 illustre l'étape E202 du procédé de fabrication représenté sur la figure 15,
La figure 17 illustre l'étape E204 du procédé de fabrication représenté sur la figure 15,
La figure 18 illustre l'étape E206 du procédé de fabrication représenté sur la figure 15, et
La figure 19 illustre l'étape E208 du procédé de fabrication représenté sur la figure 15.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication des dispositifs de stockage ferroélectriques. En particulier, la présente invention concerne un dispositif de stockage à haute densité dans lequel plusieurs états de polarisation sont utilisés pour mémoriser les informations. La présente invention vise alors à améliorer la définition des états de polarisation afin d'être en mesure de clairement les distinguer pour pouvoir ensuite lire l'information mémorisée et associée à chacun des états de polarisation.

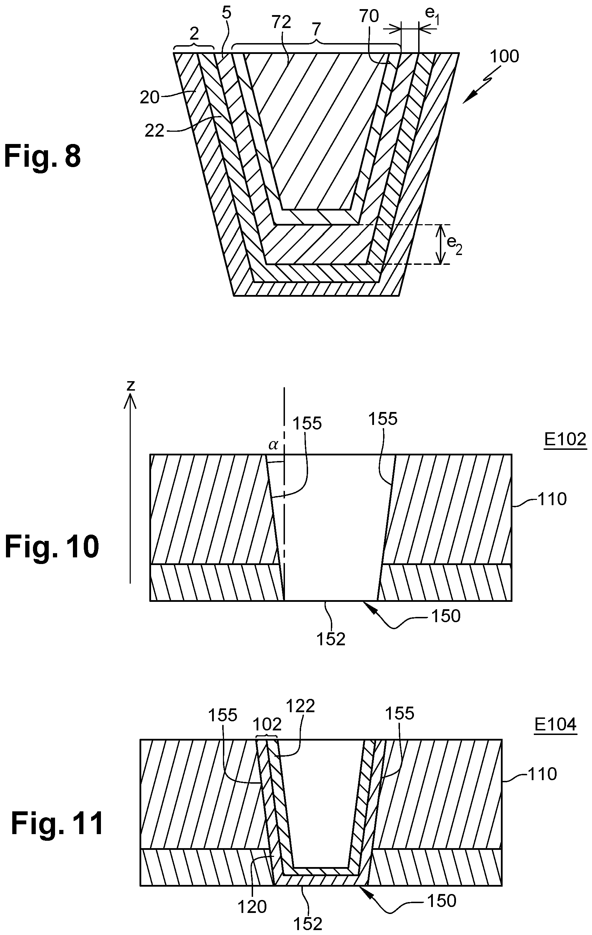

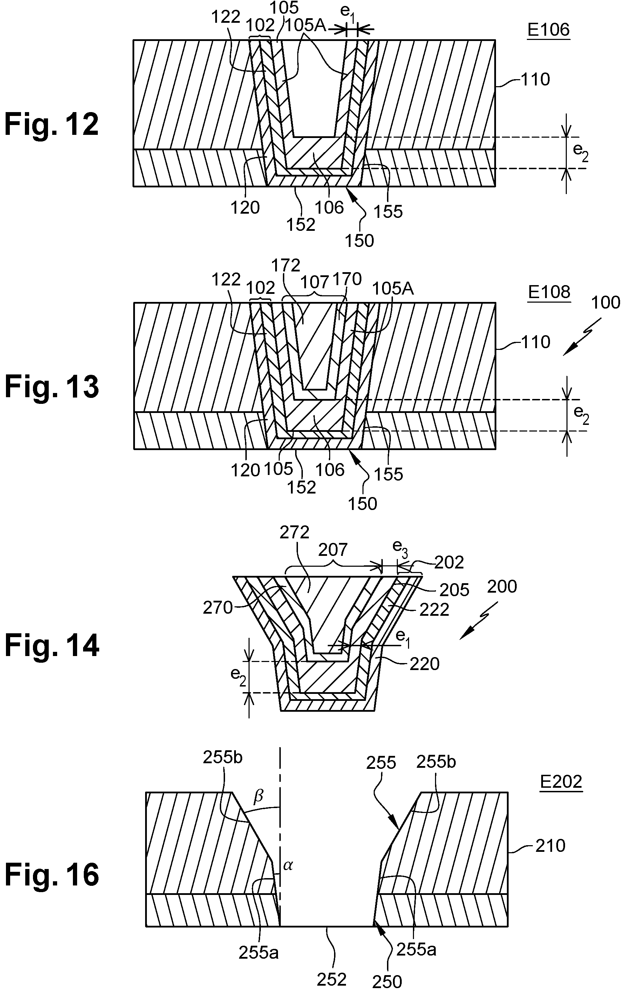

Les figures 2, 8 et 14 représentent chacune un dispositif 1 ; 100 ; 200 de stockage ferroélectrique conforme à l'invention. La figure 2 représente le dispositif 1 de stockage ferroélectrique selon un premier mode de réalisation. La figure 8 représente le dispositif 100 de stockage ferroélectrique selon un deuxième mode de réalisation. La figure 14 représente le dispositif 200 de stockage ferroélectrique selon un troisième mode de réalisation.

Quel que soit le mode de réalisation, comme cela est visible sur les figures 2, 8 et 14, le dispositif 1 ; 100 ; 200 de stockage ferroélectrique comprend une première couche 2 ; 102 ; 202, une deuxième couche 7 ; 107 ; 207 et une couche de matériau ferroélectrique 5 ; 105 ; 205 qui disposée entre la première couche 2 ; 102 ; 202 et la deuxième couche 7 ; 107 ; 207.

Comme cela est visible sur les figures 2, 8 et 15, le dispositif 1 ; 100 ; 200 se présente sous la forme d'un empilement de couches. La première couche 2 ; 102 ; 202, la couche de matériau ferroélectrique 5 ; 105 ; 205 et la deuxième couche 7 ; 107 ; 207 forment les différentes couches de cet empilement.

Dans le premier mode de réalisation visible sur la figure 2, l'empilement s'étend selon un axe z. Les différentes couches s'étendent parallèlement les unes aux autres (et parallèlement à une couche support 10 représentée sur les figures 4 à 7). L'axe z est ici perpendiculaire au plan des différentes couches de l'empilement formant le dispositif 1 de stockage ferroélectrique selon le premier mode de réalisation.

Comme cela est représenté sur les figures 4 à 7, la couche support 10 comprend par exemple au moins un via 11 destiné à connecter le dispositif 1 de stockage ferroélectrique à des niveaux métalliques inférieurs (par exemple en cuivre Cu). Le via 11 est par exemple formé en tungstène W.

En variante, la première couche peut être disposée sur un substrat non représenté ou sur une autre couche.

Dans les deuxième et troisième modes de réalisation, comme cela est décrit plus en détails par la suite avec les procédés de fabrication associés, le dispositif de stockage ferroélectrique 100 ; 200 est formé dans une cavité 150 ; 250. Cette cavité 150 ; 250 est par exemple formée dans une couche support 110 ; 210. Ici, une cavité 150 ; 250 unique est formée dans la couche support 110 ; 210. En d'autres termes, la cavité 150 ; 250 forme une partie de la couche support qui présente un profil globalement en forme de « U » (comme cela sera vu par la suite, les branches latérales de la forme en « U » sont ici inclinées par rapport à la base de la forme en « U »). Dans ces modes de réalisation, les différentes couches du dispositif de stockage ferroélectrique 100 ; 200 présentent un profil de forme similaire à la partie 150 ; 250 avec un profil en forme de « U » de la couche support 110 ; 210.

Cette couche support 110 ; 210 est par exemple formé d'un matériau diélectrique. La couche support peut comprendre une pluralité de sous-couches. Par exemple, la couche support peut comprendre une autre couche en matériau diélectrique formée sous la couche comprenant de l'oxyde de silicium SiO₂. Cette autre couche comprend par exemple du nitrure de silicium SiN ou du carbonitrure de silicium SiCN.

La cavité 150 ; 250 comprend une paroi de fond 152 ; 252 et une paroi latérale 155 ; 255, 257. La paroi de fond 152 ; 252 correspond à la base de la forme en « U » et la paroi latérale 155 ; 255, 257 correspond aux branches latérales de la forme en « U ». La paroi latérale 155 ; 255, 257 forme un premier angle d'inclinaison α ; β non nul par rapport à un axe z, correspondant à une direction normale à la paroi de fond 152 ; 252.

Dans le deuxième mode de réalisation représenté sur la figure 8, le premier angle d'inclinaison α est par exemple compris entre 13 et 50 degrés, de préférence entre 15 et 35 degrés. De manière préférentielle, ce premier angle d'inclinaison α est de l'ordre de 18 degrés.

Dans le troisième mode de réalisation visible sur la figure 14, la paroi latérale 255 de la cavité 250 comprend une première portion 255a et une deuxième portion 255b. La première portion 255a forme un premier angle d'inclinaison α non nul par rapport à l'axe z. La deuxième portion 255b forme un deuxième angle d'inclinaison β non nul par rapport à l'axe z. En d'autres termes, dans ce troisième mode de réalisation, la paroi latérale 255 de la cavité 250 présente une rupture de pente, avec la première portion inclinée 255a inclinée selon le premier angle d'inclinaison α et la deuxième portion 255b inclinée selon le deuxième angle d'inclinaison β.

Le deuxième angle d'inclinaison β est supérieur au premier angle d'inclinaison α.

Le deuxième angle d'inclinaison β est par exemple compris 15 et 70 degrés, de préférence entre 20 et 40 degrés. De manière préférentielle, ce deuxième angle d'inclinaison β est de l'ordre de 20 degrés.

Dans ces deuxième et troisième mode de réalisation, l'empilement (formant le dispositif de stockage 100 ; 200) s'étend à partir de la paroi de fond 152 ; 252 et de la paroi latérale 155 ; 255. Cet empilement comprend alors plusieurs parties : une s'étendant depuis la paroi de fond 152 ; 252 et une autre s'étendant depuis la paroi latérale 155 ; 255 (dans le troisième mode de réalisation, une partie s'étend depuis la première portion 255a de la paroi latérale 255 et une autre partie s'étend depuis la deuxième portion 255b de la paroi latérale 255). Pour la partie formée sur la paroi de fond 152 ; 252, les différentes couches de l'empilement s'étendent parallèlement les unes aux autres. Il en est de même pour la partie s'étendant depuis la paroi latérale 155 ; 255 (les différentes couches de l'empilement s'étendent également parallèlement les unes aux autres sur cette paroi latérale 155 ; 255).

En variante, la paroi latérale de la cavité pourrait bien entendu comprend un nombre supérieur à 2 de portions formant des angles distincts par rapport à une direction normale à la paroi de fond. En d'autres termes, la paroi latérale de la cavité peut présenter une pluralité de ruptures de pente.

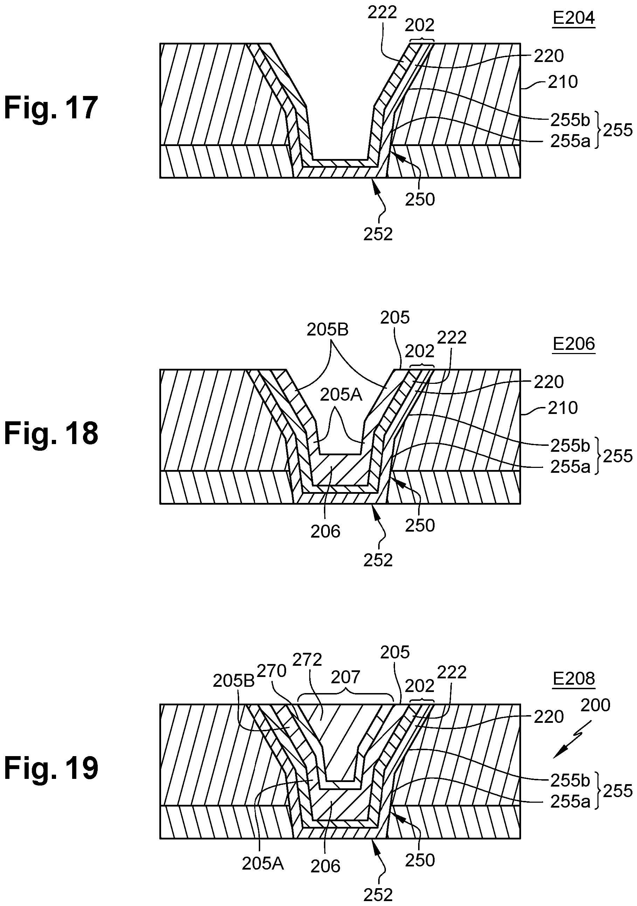

En pratique, comme cela est visible sur les figures 12 et 18, la surface de contact entre la première couche 102 ; 202 et la couche de matériau ferroélectrique 105 ; 205 est parallèle à la surface de contact entre la première couche 102 ; 202 et la cavité 150 ; 250. Dans la présente description, l'expression « surface de contact » fait référence à l'interface entre les deux couches concernées.

Plus particulièrement ici, la surface de contact entre la première couche 102 ; 202 et la couche de matériau ferroélectrique 105 ; 205 est parallèle en tout point à la surface de contact entre la première couche 102 ; 202 et la cavité 150 ; 250. En d'autres termes, chaque portion de la surface de contact entre la première couche 102 ; 202 et la couche de matériau ferroélectrique 105 ; 205 est parallèle à la portion de la surface de contact entre la première couche 102 ; 202 et la cavité 150 ; 250 lui faisant face. En d'autres termes encore, la première couche 102 ; 202 et la couche de matériau ferroélectrique 105 ; 205 s'étendent parallèlement l'une par rapport à l'autre sans aucune portion repliée de l'une ou l'autre des couches (de la première couche ou de la couche de matériau ferroélectrique).

Chacune des couches formant le dispositif 1 ; 100 ; 200 de stockage ferroélectrique est à présent décrite.

La première couche 2 ; 102 ; 202 est formée d'un matériau conducteur inerte. Cette première couche 2 ; 102; 202 comprend par exemple un matériau métallique.

Selon un premier exemple (non représenté), la première couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur un deuxième exemple représenté sur les figures 2, 8 et 14, la première couche 2 ; 102 ; 202 se présente ici sous la forme d'une structure bicouche. Elle comprend ici une première sous-couche 20 ; 120 ; 220 et une deuxième sous-couche 22 ; 122 ; 222.

La deuxième sous-couche 22 ; 122 ; 222 est disposée sur la première sous-couche 20 ; 120 ; 220.

La première sous-couche 20 ; 120 ; 220 comprend un matériau conducteur métallique. De préférence, elle comprend du titane Ti ou du nitrure de tantale TaN.

La première sous-couche 20 ; 120 ; 220 présente une épaisseur comprise entre 3 et 20 nanomètres (nm). De préférence, cette épaisseur est comprise entre 5 et 10 nm.

Cette première sous-couche 20 ; 120 ; 220 joue à la fois le rôle d'une couche de protection, et le rôle d'une couche de contact permettant de raccorder électriquement le dispositif 1 ; 100 ; 200 à son circuit électronique de pilotage et de lecture.

La deuxième sous-couche 22 ; 122 ; 222 est disposée sur la première sous-couche 20 ; 120 ; 220. Elle est en contact direct avec la couche de matériau ferroélectrique 5 ; 105 ; 205. En d'autres termes, la deuxième sous-couche 22 ; 122 ; 222 s'étend entre la première sous-couche 20 ; 120 ; 220 et la couche de matériau ferroélectrique 5 ; 105 ; 205.

La deuxième sous-couche 22 ; 122 ; 222 est formée d'un matériau conducteur comprenant un métal de transition. Ce matériau conducteur est par exemple du nitrure de titane TiN. En variante, il peut s'agir d'autres matériaux conducteurs tels que du tantale Ta ou du tungstène W.

Par exemple, lorsque la deuxième sous-couche 22 ; 122 ; 222 comprend du nitrure de titane, la première sous-couche 20 ; 120 ; 220 est formée d'un matériau conducteur comme le titane Ti.

En variante, lorsque la deuxième sous-couche 22 ; 122 ; 222 comprend du tantale, la première sous-couche 20 ; 120 ; 220 est formée par exemple de nitrure de tantale TaN.

En variante encore, lorsque la deuxième sous-couche 22 ; 122 ; 222 comprend du tungstène, la première sous-couche 20 ; 120 ; 220 est formée d'un matériau conducteur en titane Ti.

Ici, l'épaisseur de la deuxième sous-couche 22 ; 122 ; 222 est comprise entre 10 et 100 nm. De préférence, cette épaisseur est comprise entre 5 et 10 nm.

En variante, la première couche peut comprendre un matériau semi-conducteur. Ce matériau semi-conducteur comprend par exemple du silicium.

La couche de matériau ferroélectrique 5 ; 105 ; 205 est disposée sur la première couche 2 ; 102 ; 202. En variante, la couche de matériau ferroélectrique peut être déposée sur une autre couche présente, au préalable, sur la première couche.

Cette couche de matériau ferroélectrique 5 ; 105 ; 205 est par exemple à base de dioxyde d'hafnium HfO₂. Dans la présente description, on entend par l'expression « à base de » que la couche concernée comprend plus de 50% de l'élément mentionné après cette expression (par exemple ici, cela signifie que la couche de matériau ferroélectrique 5 ; 105 ; 205 comprend plus de 50% de dioxyde d'hafnium).

En variante, le dioxyde d'hafnium peut être dopé par un élément dopant. Dans la présente description, l'expression « dopage » d'une couche correspond à l'introduction dans le matériau de la couche concernée des atomes d'un autre matériau appelés « élément dopant ».

Ici, l'élément dopant préférentiellement utilisé est du silicium Si. Dans le cas du silicium, la couche de matériau ferroélectrique à base de dioxyde d'hafnium est par exemple exposée à une dose de dopant comprise entre 1.10¹⁴ cm⁻² et 1.10¹⁵ cm⁻² afin d'obtenir une présence comprise entre 0,7 à 7% d'atomes de silicium dans la couche de matériau ferroélectrique. De préférence, la dose de dopant est comprise entre 0,3.10¹⁵ cm⁻² et 1.10¹⁵ cm⁻².

En variante, d'autres éléments dopants peuvent être utilisés comme de l'aluminium Al, du germanium Ge, du gadolinium Gd, de l'Yttrium Y, du lanthane La, du scandium Sc ou de l'azote N.

En variante encore, la couche de matériau ferroélectrique peut comprendre un alliage de la forme HfₓZr₁₋ₓO₂, avec 0<x<1. Par exemple, il est possible d'utiliser un alliage ternaire HfZrO₂ (par exemple du Hf_{0.5}Zr_{0.5}O₂) en tant que matériau ferroélectrique. En variante encore, la couche de matériau ferroélectrique peut être en nitrure d'aluminium scandium (AIScN).

Comme cela est visible sur les figures 2, 8 et 14, la couche de matériau ferroélectrique 5 ; 105 ; 205 comprend au moins une première partie 5A ; 105A ; 205A et une deuxième partie 6 ; 106 ; 206. Dans le cas du dispositif 200 de stockage ferroélectrique selon le troisième mode de réalisation, la couche de matériau ferroélectrique 205 comprend une troisième partie 205B.

Dans le premier mode de réalisation du dispositif 1 de stockage ferroélectrique (visible sur la figure 2), la deuxième partie 6 de la couche de matériau ferroélectrique 5 présente au moins deux sous-portions 6B, 6C encadrant la première partie 5A. Autrement dit, chacune des deux sous-portions 6B, 6C est disposée de part et d'autre de la première partie 5A de la couche de matériau ferroélectrique 5.

Dans le deuxième mode de réalisation du dispositif 100 de stockage ferroélectrique (représenté sur la figure 8), la première partie 105A s'étend le long de la paroi latérale 155 de la cavité 150 tandis que la deuxième partie 106 s'étend le long de la paroi de fond 152 de la cavité 150.

Dans le troisième mode de réalisation du dispositif 200 de stockage ferroélectrique (illustré sur la figure 14), la première partie 205A s'étend le long d'une première portion 255a de la paroi latérale 255 de la cavité 250, la deuxième partie 206 s'étend le long de la paroi de fond 252 et la troisième partie 205B de la couche de matériau ferroélectrique s'étend le long de la deuxième portion 255b de la paroi latérale 255 de la cavité 250.

De manière avantageuse selon l'invention, la première partie 5A ; 105A ; 205A présente une première épaisseur e₁ et la deuxième partie 6 ; 106 ; 206 présente une deuxième épaisseur e₂. Dans la présente invention, on définit l'épaisseur d'une partie d'une couche comme la distance séparant les deux faces de la partie de la couche concernée. En d'autres termes, l'épaisseur correspond à la dimension caractéristique de la couche concernée dans une direction parallèle à une direction normale aux faces de la partie concernée de la couche.

Par exemple, dans le cas de la figure 2, la couche de matériau ferroélectrique 5 présente une première face 10A et une deuxième face 10B. Ici, la face 10A est en contact avec la première couche 2 et la face 10B est en contact avec la deuxième couche 7.

Ici, la première épaisseur e₁ et la deuxième épaisseur e₂ sont distinctes. Autrement dit, la couche de matériau ferroélectrique 5 ; 105; 205 présente une épaisseur non-uniforme. En d'autres termes encore, la couche de matériau ferroélectrique 5 ; 105 ; 205 présente une épaisseur variable.

Les différences d'épaisseurs forment des caractéristiques primordiales du dispositif de stockage ferroélectrique pour obtenir les différents états de polarisation.

Ainsi, grâce à l'invention, les différences d'épaisseurs utilisées pour la couche de matériau ferroélectrique introduisent une non-uniformité dans les propriétés ferroélectriques de la couche de matériau ferroélectrique. Cette non-uniformité des propriétés permet notamment d'augmenter les différences entre les gammes de tensions à appliquer pour encoder les informations dans les différents états de polarisation intermédiaires. Cela permet alors d'éviter le recouvrement entre les gammes de tensions concernées et donc d'identifier sans ambiguïté les états de polarisation intermédiaires concernés par les informations mémorisées.

Afin d'obtenir des états de polarisation bien distincts (i.e. sans recouvrement entre les gammes de tensions à appliquer pour les atteindre), le rapport entre la deuxième épaisseur e₂ et la première épaisseur e₁ est de préférence compris entre 2 et 4.

En pratique, la première épaisseur e₁ est par exemple comprise entre 3 et 7 nm. De préférence, cette première épaisseur e₁ est de l'ordre de 4 nm.

La deuxième épaisseur e₂ est par exemple comprise entre 8 et 17 nm. De préférence, cette deuxième épaisseur e₂ est de l'ordre de 10 nm.

Ici, la deuxième épaisseur e₂ est donc supérieure à la première épaisseur e₁. Cela implique alors qu'il sera nécessaire d'appliquer une plus forte tension pour permettre l'encodage des informations mémorisées dans l'état de polarisation intermédiaire associé à la deuxième épaisseur e₂ (en comparaison de la première épaisseur e₁).

Les gammes d'épaisseurs considérées dans l'invention permettent d'accentuer les non-uniformités des propriétés ferroélectriques de la couche de matériau ferroélectrique, de manière à permettre la mémorisation des informations sur différents états de polarisation intermédiaires et à permettre l'encodage de ces informations en distinguant distinctement ces différents états.

Par ailleurs, dans un plan orthogonal à la direction permettant de définir l'épaisseur, on définit une surface de la première partie 5A ; 105A ; 205A au niveau de l'une des faces de la couche de matériau ferroélectrique 5 ; 105 ; 205. Il est également possible de définir la surface totale de la couche de matériau ferroélectrique 5 ; 105 ; 205 comme la surface de l'une des faces de la couche de matériau ferroélectrique 5 ; 105 ; 205. Autrement dit, la surface de la première partie 5A ; 105A ; 205A correspond à une partie de la surface totale de la couche de matériau ferroélectrique 5 ; 105 ; 205.

De manière avantageuse selon l'invention, la première partie 5A ; 105A ; 205A présente une surface d'au moins 15% de la surface totale de la couche de matériau ferroélectrique 5 ; 105 ; 205. En d'autres termes, la surface de la première partie 5A ; 105A ; 205A représente au moins 15% de la surface totale de la couche de matériau ferroélectrique 5 ; 105 ; 205.

Ainsi, avantageusement selon l'invention, les non-uniformités (associées aux différences d'épaisseurs) de la couche de matériau ferroélectrique ne sont pas des artefacts de fabrication. Le fait que les parties associées aux différentes épaisseurs présentent des surfaces conséquentes permet de s'assurer d'états de polarisation bien distincts (et donc d'une absence de recouvrement entre les gammes de tensions à appliquer pour accéder aux différents états de polarisation).

Comme le montrent les figures 2, 8 et 14, la deuxième couche 7 ; 107 ; 207 est disposée sur la couche de matériau ferroélectrique 5 ; 105 ; 205.

Cette deuxième couche 7 ; 107 ; 207 comprend par exemple un matériau conducteur. Il s'agit notamment d'un matériau métallique.

Selon un premier exemple (non représenté), la deuxième couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur les figures 2, 8 et 14, la deuxième couche 7 ; 107 ; 207 se présente ici sous la forme d'une structure bicouche. Elle comprend ici une première sous-couche 70 ; 170 ; 270 et une deuxième sous-couche 72 ; 172 ; 272.

La deuxième sous-couche 72 ; 172 ; 272 de la deuxième couche 7 ; 107 ; 207 est disposée sur la première sous-couche 70 ; 170 ; 270 associée.

La deuxième sous-couche 72 ; 172 ; 272 est formée d'un matériau conducteur comprenant un métal de transition. Ce matériau conducteur est par exemple du nitrure de titane TiN. En variante, il peut s'agir d'autres matériaux conducteurs tels que du nitrure de tantale TaN ou du tungstène W.

La deuxième sous-couche 72 ; 172 ; 272 présente une épaisseur comprise entre 10 et 200 nm.

Cette deuxième sous-couche 72 ; 172 ; 272 joue à la fois le rôle d'une couche de protection, et le rôle d'une couche de contact permettant de raccorder électriquement le dispositif 1 ; 100 ; 200 à son circuit électronique de pilotage et de lecture.

La première sous-couche 70 ; 170 ; 270 est disposée sur la couche de matériau ferroélectrique 5 ; 105 ; 205. Elle est en contact direct avec la couche de matériau ferroélectrique 5 ; 105 ; 205. En d'autres termes, la première sous-couche 70 ; 170 ; 270 de la deuxième couche 7 ; 107 ; 207 s'étend entre la deuxième sous-couche 72 ; 172 ; 272 et la couche de matériau ferroélectrique 5 ; 105 ; 205.

La deuxième sous-couche 72 ; 172 ; 272 comprend un matériau conducteur métallique. De préférence, elle comprend du titane Ti ou du tantale Ta.

Par exemple, lorsque la deuxième sous-couche 72 ; 172 ; 272 comprend du nitrure de titane, la première sous-couche 70 ; 170 ; 270 est formée d'un matériau conducteur comme le titane Ti.

En variante, lorsque la deuxième sous-couche 72 ; 172 ; 272 comprend du nitrure de tantale, la première sous-couche 70 ; 170 ; 270 est formée d'un matériau conducteur comme le tantale Ta.

En variante encore, lorsque la deuxième sous-couche 72 ; 172 ; 272 comprend du tungstène, la première sous-couche 70 ; 170 ; 270 est formée d'un matériau conducteur choisi parmi le titane Ti ou le tantale Ta.

Ici, l'épaisseur de la première sous-couche 70 ; 170 ; 270 est comprise entre 3 et 20 nm.

En pratique, dans le cas d'une mémoire de type OxRAM (pour « *Oxide Resistive RAM »),* lorsque cette structure bicouche est utilisée pour la deuxième couche 7 ; 107 ; 207, la première sous-couche 70 ; 170 ; 270 présente également la particularité d'être une couche qui va permettre la création de lacunes d'oxygène dans la couche de matériau ferroélectrique 5 ; 105 ; 205 (lorsque cette première sous-couche 70 ; 170 ; 270 est en contact avec la couche de matériau ferroélectrique 5 ; 105 ; 205). Dans ce cas, la première sous-couche 70 ; 170 ; 270 comprend un matériau conducteur choisi parmi le titane Ti ou le tantale Ta et la deuxième sous-couche 72 ; 172 ; 272 comprend un nitrure de titane TiN ou un nitrure de tantale TaN (de manière à former une couche de protection). La création de ces lacunes d'oxygène permet alors d'améliorer les performances du dispositif de stockage ferroélectrique en facilitant les échanges d'oxygène avec la couche de matériau ferroélectrique.

Dans le cas d'une mémoire de type FeRAM, la deuxième couche 7 ; 107 ; 207 comprend par exemple un nitrure métallique ou un métal qui ne s'oxyde pas (tel que la tungstène W ou le ruthénium Ru.

Dans le cas d'une mémoire de type FTJ, la structure utilisée est celle d'une mémoire de type FeRAM avec l'introduction d'une couche comprenant un matériau diélectrique entre la couche de matériau ferroélectrique 5 ; 105 ; 205 et la deuxième couche 7 ; 107 ; 207. Le matériau diélectrique est par exemple un oxyde diélectrique tel que l'oxyde d'aluminium Al₂O₃ ou le dioxyde de silicium SiO₂.

En variante, la deuxième couche peut comprendre un matériau semi-conducteur. Ce matériau semi-conducteur comprend par exemple du silicium.

De manière avantageuse selon l'invention, le dispositif de stockage ferroélectrique comprend une couche de matériau ferroélectrique dont l'épaisseur est variable. Cette variabilité d'épaisseur entraîne une non-uniformité dans les propriétés ferroélectriques du dispositif de stockage ferroélectrique. Cette non-uniformité des propriétés permet notamment d'augmenter les différences entre les gammes de tensions à appliquer pour encoder les informations dans les différents états de polarisation intermédiaires.

En d'autres termes, grâce à la non-uniformité créée dans la couche de matériau ferroélectrique (due à la variabilité d'épaisseurs), des différences entre les états de polarisation intermédiaires sont créées.

En variante, la couche de matériau ferroélectrique peut comprendre plus de trois épaisseurs distinctes. Il peut notamment s'agir d'une variation continue de l'épaisseur.

La présente invention concerne également un procédé de fabrication d'un dispositif de stockage ferroélectrique 1 ; 100 ; 200

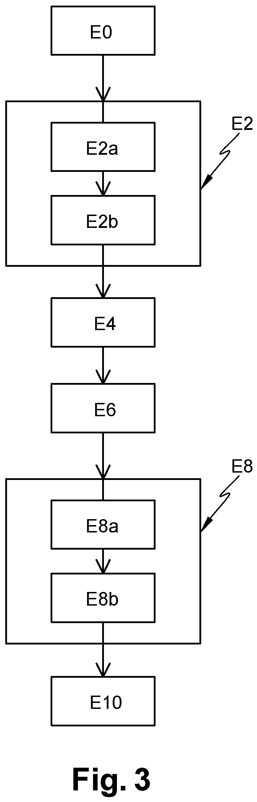

Les figures 3 à 7 concernent un premier mode de réalisation de ce procédé de fabrication conforme à l'invention. Ce premier mode de réalisation du procédé de fabrication permet la fabrication du dispositif 1 de stockage ferroélectrique représenté sur la figure 2.

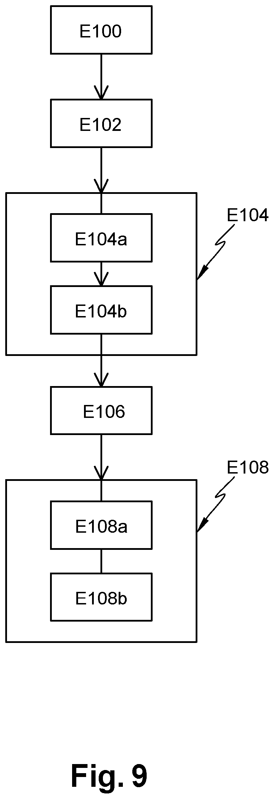

Les figures 9 à 13 concernent un deuxième mode de réalisation de ce procédé de fabrication conforme à l'invention. Ce deuxième mode de réalisation du procédé de fabrication permet la fabrication du dispositif 100 de stockage ferroélectrique représenté sur la figure 8.

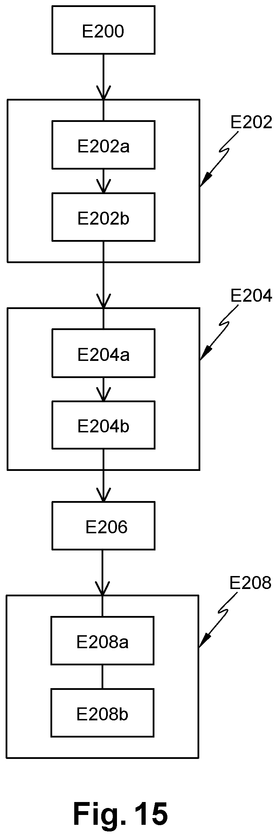

Les figures 15 à 19 concernent un troisième mode de réalisation du procédé de fabrication conforme à l'invention. Ce troisième mode de réalisation du procédé de fabrication permet la fabrication du dispositif 200 de stockage ferroélectrique représenté sur la figure 15.

La figure 3 représente, sous forme de logigramme, un exemple du procédé de fabrication selon le premier mode de réalisation.

Comme cela est visible sur cette figure, le procédé de fabrication comprend tout d'abord une étape E0 de fourniture d'une couche support 10 sur laquelle va être formé le dispositif 1 de stockage ferroélectrique. Comme indiqué précédemment, cette couche support 10 est munie d'au moins un via 11 destiné à connecter le dispositif 1 de stockage ferroélectrique à des niveaux métalliques inférieurs.

En variante, cette étape peut être une étape de fourniture d'un substrat.

Le procédé de fabrication se poursuit ensuite par une étape E2 de dépôt de la première couche 2. Cette étape vise donc à former la première couche 2 sur la couche support 10 (ou sur un substrat non représenté).

Il s'agit ici d'un dépôt conforme de la première couche 2. Dans cette description, on entend par « dépôt conforme » un dépôt mis en oeuvre de telle façon que la couche présente une épaisseur sensiblement constante en tout point. Dans cette description, on entend par « sensiblement constante », une épaisseur ne variant pas de plus de 20 %, de préférence de plus de 10 %, et de préférence encore de plus de 5%.

Comme indiqué précédemment, la première couche 2 comprend ici une première sous-couche 20 et une deuxième sous-couche 22.

L'étape E2 de dépôt de la première couche 2 comprend donc ici deux sous-étapes : une première sous-étape E2a de dépôt de la première sous-couche 20 et une deuxième sous-étape E2b de dépôt de la deuxième sous-couche 22.

La première sous-couche 20 est donc tout d'abord déposée, de manière conforme, sur la couche support 10 (ou sur un substrat non représenté). En pratique, la première sous-couche 20 est par exemple formée par pulvérisation cathodique dans une chambre de dépôt sous vide. Dans le cas où la première sous-couche 20 est formée en nitrure de titane, il s'agit d'une pulvérisation cathodique réactive.

En variante, la première sous-couche peut être formée par un dépôt chimique en phase vapeur.

Puis, la deuxième sous-couche 22 de la première couche 2 est déposée, de manière conforme, sur la première sous-couche 20. La deuxième sous-couche 22 est par exemple formée par pulvérisation cathodique dans une chambre de dépôt sous vide. En pratique, la deuxième sous-couche 22 de la première couche 2 est formée dans la même chambre de dépôt que la première sous-couche 20 de la première couche 2.

Dans le cas où la deuxième sous-couche 22 est formée en nitrure de titane, il s'agit d'une pulvérisation cathodique réactive.

En variante, la première couche 2 peut être déposée par une méthode de dépôt par couche atomique (ou ALD pour *« Atomic Layer Deposition »* selon l'acronyme d'origine anglo-saxonne couramment utilisé).

Puis le procédé se poursuit à l'étape E4 de dépôt de la couche de matériau ferroélectrique 5 sur la première couche 2. Plus particulièrement, la couche de matériau ferroélectrique 5 est déposée sur la deuxième sous-couche 22 de la première couche 2. Cette étape E4 est représentée sur la figure 4.

Il s'agit ici d'un dépôt conforme de la couche de matériau ferroélectrique 5 sur la première couche 2.

Ici, l'étape E4 de dépôt est par exemple mise en oeuvre de telle façon que la couche de matériau ferroélectrique présente une épaisseur e₂.

En pratique, la couche de matériau ferroélectrique 5 est déposée par une méthode de dépôt par couche atomique (ou ALD).

En variante, la couche de matériau ferroélectrique peut être déposée par pulvérisation cathodique. En variante encore, la couche de matériau ferroélectrique peut être déposée par une méthode de dépôt physique en phase vapeur (ou PVD pour *« Physical Vapor Deposition »).* En variante encore, la couche de matériau ferroélectrique peut être déposée par une méthode de dépôt par faisceau d'ions (ou IBD pour « *Ion Beam Deposition* »).

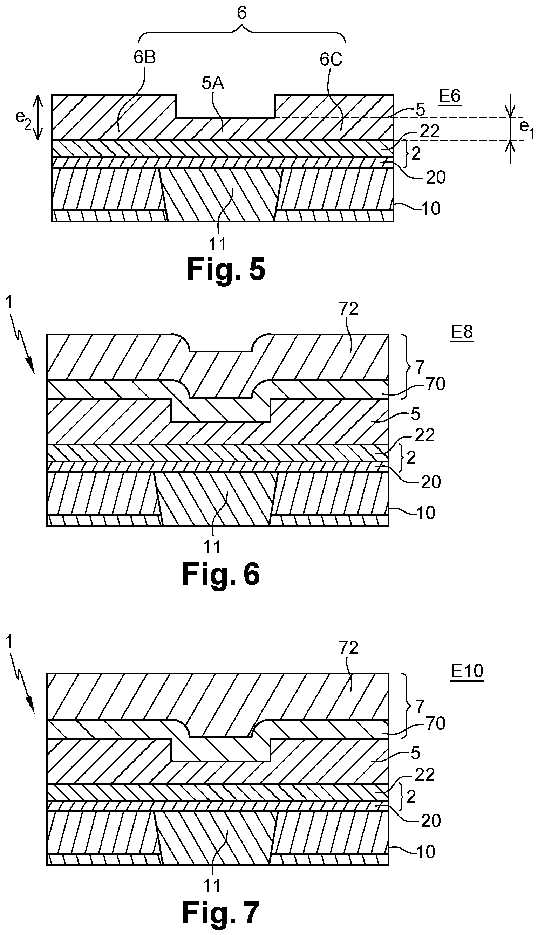

Puis, comme le montre la figure 3, le procédé se poursuit par une étape E6 de retrait d'une portion de la couche de matériau ferroélectrique 5 formée à l'étape E4. Cette étape E6 est représentée sur la figure 5.

Cette étape de retrait permet alors de former la première partie 5A et la deuxième partie 6 de la couche de matériau ferroélectrique 5. En d'autres termes, la portion retirée de la couche de matériau ferroélectrique 5 est telle que la partie restante (de couche de matériau ferroélectrique 5) présente une épaisseur e₁. Cette portion restante correspond alors à la première partie 5A de la couche de matériau ferroélectrique 5.

En pratique, cette étape E6 de retrait est réalisée par lithographie puis gravure. Elle est par exemple mise en oeuvre par photolithogravure.

Ainsi, grâce à cette étape de retrait, la couche de matériau ferroélectrique comprend la première partie 5A présentant la première épaisseur e₁ et la deuxième partie 6 présentant la deuxième épaisseur e₂. Comme indiqué précédemment, la première épaisseur e₁ et la deuxième épaisseur e₂ sont distinctes.

Comme indiqué précédemment, la deuxième épaisseur e₂ est supérieure à la première épaisseur e₁. Cela implique alors qu'il sera nécessaire d'appliquer une plus forte tension pour permettre d'encoder les informations mémorisées dans l'état de polarisation intermédiaire associé à la deuxième partie 6 (en comparaison de la première partie 5A).

Le procédé se poursuit ensuite, à l'étape E8, par le dépôt de la deuxième couche 7. Cette étape E8 est représentée sur la figure 6.

La deuxième couche 7 est formée sur la couche de matériau ferroélectrique 5 obtenue à l'issue de l'étape E6.

Le dépôt de la deuxième couche 7 est également mis en oeuvre de manière conforme.

Comme indiqué précédemment, la deuxième couche 7 comprend ici une première sous-couche 70 et une deuxième sous-couche 72.

L'étape E8 de la deuxième couche 7 comprend donc ici deux sous-étapes : une première sous-étape E8a de dépôt de la première sous-couche 70 et une deuxième sous-étape E8b de dépôt de la deuxième sous-couche 72.

La première sous-couche 70 est donc tout d'abord déposée, de manière conforme, sur la couche de matériau ferroélectrique 5. En pratique, la première sous-couche 70 est par exemple formée par pulvérisation cathodique dans une chambre de dépôt sous vide. Dans le cas où la première sous-couche 70 est formée en nitrure de titane, il s'agit d'une pulvérisation cathodique réactive.

En variante, la première sous-couche peut être formée par un dépôt chimique en phase vapeur.

Puis, la deuxième sous-couche 72 de la deuxième couche 7 est déposée, de manière conforme, sur la première sous-couche 70. La deuxième sous-couche 72 est par exemple formée par pulvérisation cathodique dans une chambre de dépôt sous vide. En pratique, la deuxième sous-couche 72 de la deuxième couche 7 est formée dans la même chambre de dépôt que la première sous-couche 70 de la deuxième couche 7.

Dans le cas où la deuxième sous-couche 72 est formée en nitrure de titane, il s'agit d'une pulvérisation cathodique réactive.

Comme cela est visible sur la figure 6, comme la couche de matériau ferroélectrique 5 comprend la première partie 5A d'épaisseur e₁ plus faible que la deuxième partie 6 d'épaisseur e₂, lorsque la deuxième couche 7 est déposée, cette dernière ne présente pas une surface libre plane.

Le procédé de fabrication comprend alors une étape E10 de planarisation. Cette étape E10 consiste à aplanir et uniformiser la surface de la deuxième couche 7. Cette étape E10 est représentée sur la figure 7.

En pratique, cette étape E10 est par exemple mise en oeuvre par polissage mécanochimique (ou CMP pour « *Chemical mechanical polishing* » selon l'acronyme d'origine anglosaxonne couramment utilisé).

Cette étape de planarisation est particulièrement avantageuse car, grâce à l'uniformisation de la surface de la deuxième couche, elle permet d'améliorer les performances électriques du dispositif de stockage ferroélectrique et de garantir une meilleure qualité des interconnexions.

Finalement, à l'issue du procédé de fabrication selon ce premier mode de réalisation, le dispositif 1 de stockage ferroélectrique obtenu comprend une couche de matériau ferroélectrique à épaisseur variable. Cette variabilité d'épaisseurs permet d'introduire une non-uniformité dans les propriétés ferroélectriques de la couche de matériau ferroélectrique. Cette non-uniformité des propriétés permet notamment d'augmenter les différences entre les gammes de tensions à appliquer pour mémoriser les informations dans les différents états de polarisation intermédiaires. Cela permet alors d'éviter le recouvrement entre les gammes de tensions concernées et donc d'identifier sans ambiguïté les états de polarisation intermédiaires concernés par les informations mémorisées.

Le dispositif 1 de stockage ferroélectrique obtenue à l'issue du procédé de fabrication selon ce premier mode de réalisation présente une architecture dite « planaire », avec un empilement de couches parallèles entre elles. Cette configuration présente l'avantage d'être facile à mettre oeuvre, notamment car les dépôts des différentes couches peuvent être réalisés de manière conforme ou non.

Selon une variante de mise en oeuvre de ce premier mode de réalisation, le procédé peut comprendre, entre l'étape E4 de dépôt de la couche de matériau ferroélectrique et l'étape E6 de retrait d'une portion de la couche de matériau ferroélectrique, une étape d'implantation d'un élément dopant dans la couche de matériau ferroélectrique formée à l'étape E4. Cette étape permet alors de doper la couche de matériau ferroélectrique par l'élément dopant.

En pratique, l'étape d'implantation est par exemple mise en oeuvre dans un réacteur différent de la chambre de dépôt de la première couche et de la couche de matériau ferroélectrique.

Ici, il s'agit par exemple d'une étape d'implantation ionique du silicium (qui est l'élément dopant) dans la couche de matériau ferroélectrique. Les doses d'implantation sont par exemple comprises entre 1.10¹⁴ cm⁻² et 1.10¹⁵ cm⁻². De préférence, la dose d'implantation est comprise entre 0,3. 10¹⁵ cm⁻² et 1.10¹⁵ cm⁻².

La figure 9 représente, sous forme de logigramme, un exemple du procédé de fabrication selon le deuxième mode de réalisation.

Comme cela est visible sur cette figure, le procédé de fabrication comprend tout d'abord une étape E100 de fourniture d'une couche support 110.

Puis, le procédé de fabrication se poursuit à l'étape E102, lors que laquelle la cavité 150 (dans laquelle va être formé le dispositif 100 de stockage ferroélectrique) est formée. Une unique cavité 150 est formée ici. La figure 10 illustre cette étape E102.

Cette étape E102 est mise en oeuvre par une gravure anisotrope de manière à former la paroi de fond 152 et la paroi latérale 155 de la cavité 150. Il s'agit par exemple ici d'une gravure chimique sèche.

Comme décrit précédemment, la paroi latérale 155 de la cavité 150 est réalisée de telle manière à former le premier angle d'inclinaison α par rapport à l'axe z parallèle à une direction normale à la paroi de fond 152.

La paroi latérale 155 forme donc un premier angle d'inclinaison α non nul par rapport à un axe z, correspondant à une direction normale à la paroi de fond 152.

Comme cela est visible sur la figure 9, le procédé de fabrication se poursuit, à l'étape E104, par le dépôt de la première couche 102. La figure 11 illustre cette étape E104.

Cette première couche 102 est déposée dans la cavité 150. Plus particulièrement, la première couche 102 est déposée le long de la paroi de fond 152 et de la paroi latérale 155 de la cavité 150. La première couche 102 présente donc la forme de la cavité 150.

Le dépôt de la première couche 102 est effectué ici de manière conforme. Par exemple, la première couche 102 peut être formée par une méthode de dépôt par couche atomique (ou ALD pour « *Atomic Layer Déposition* » selon l'acronyme d'origine anglo-saxonne couramment utilisé).

Comme indiqué précédemment, la première couche 102 comprend ici une première sous-couche 120 et une deuxième sous-couche 122.

L'étape E104 de dépôt de la première couche 102 comprend donc ici deux sous-étapes : une première sous-étape E104a de dépôt de la première sous-couche 120 et une deuxième sous-étape E104b de dépôt de la deuxième sous-couche 122.

La première sous-couche 120 est donc tout d'abord déposée, de manière conforme, dans la cavité 150 (étape E104a). En pratique, la première sous-couche 20 est par exemple formée par une méthode de dépôt par couche atomique (ou ALD) ou par dépôt chimique en phase vapeur.

En variante, la première sous-couche 120 peut être formée par pulvérisation cathodique dans une chambre de dépôt sous vide. Dans le cas où la première sous-couche 120 est formée en nitrure de titane, il s'agit d'une pulvérisation cathodique réactive.

Puis, la deuxième sous-couche 122 de la première couche 102 est déposée, de manière conforme, sur la première sous-couche 120 (étape E104b). La deuxième sous-couche 122 est par exemple formée par pulvérisation cathodique dans une chambre de dépôt sous vide. En pratique, la deuxième sous-couche 122 de la première couche 102 est formée dans la même chambre de dépôt que la première sous-couche 120 de la première couche 102.

Dans le cas où la deuxième sous-couche 122 est formée en nitrure de titane, il s'agit d'une pulvérisation cathodique réactive.

Puis, le procédé de fabrication se poursuit à l'étape E106 de dépôt de la couche de matériau ferroélectrique 105 sur la première couche 102. Plus particulièrement, la couche de matériau ferroélectrique 105 est déposée sur la deuxième sous-couche 122 de la première couche 102. Cette étape E106 est représentée sur la figure 12.

De manière avantageuse dans ce deuxième mode de réalisation, le dépôt de la couche de matériau ferroélectrique 105 est mis en oeuvre de manière non conforme. Cela signifie donc que le dépôt est réalisé de telle manière que l'épaisseur de la couche de matériau ferroélectrique 105 est variable.

Plus particulièrement ici, le dépôt est mis en oeuvre de manière à obtenir une épaisseur e₂ du matériau ferroélectrique au niveau de la paroi de fond 152 (formant ainsi la deuxième partie 106 de la couche de matériau ferroélectrique 105) et à obtenir une épaisseur e₁ du matériau ferroélectrique au niveau de la paroi latérale 155 (formant ainsi la première partie 105A de la couche de matériau ferroélectrique 105).

En pratique, l'étape E106 de dépôt (non conforme) est par exemple mise en oeuvre par une méthode de dépôt physique en phase vapeur (ou PVD pour « *Physical Vapor Déposition »).*

En variante, la couche de matériau ferroélectrique peut être déposée par pulvérisation cathodique. En variante encore, la couche de matériau ferroélectrique peut être déposée par une méthode de dépôt par faisceau d'ions (ou IBD pour « *Ion Beam Déposition »).*

Ce dépôt non conforme permet de former directement la couche de matériau ferroélectrique 105 avec une première partie 105A qui présente la première épaisseur e₁ et une deuxième partie 106 qui présente la deuxième épaisseur e₂. Comme indiqué précédemment, la deuxième épaisseur e₂ est supérieure à la première épaisseur e₁. Cela implique alors qu'il sera nécessaire d'appliquer une plus forte tension pour permettre d'encoder les informations mémorisées dans l'état de polarisation intermédiaire associé à la deuxième partie 106 (en comparaison de la première partie 105).

Le procédé se poursuit ensuite, à l'étape E108, par le dépôt de la deuxième couche 107. Cette étape E108 est représentée sur la figure 13.

La deuxième couche 107 est formée sur la couche de matériau ferroélectrique 105 obtenue à l'issue de l'étape E106.

Le dépôt de la deuxième couche 107 est réalisé de manière conforme.

Comme indiqué précédemment, la deuxième couche 107 comprend ici une première sous-couche 170 et une deuxième sous-couche 172.

L'étape E108 de dépôt de la deuxième couche 107 comprend donc ici deux sous-étapes : une première sous-étape E108a de dépôt de la première sous-couche 170 et une deuxième sous-étape 108b de dépôt de la deuxième sous-couche 172.

La première sous-couche 170 est donc tout d'abord déposée, de manière conforme, sur la couche de matériau ferroélectrique 105 (étape E108a). En pratique, la première sous-couche 170 est par exemple formée par pulvérisation cathodique dans une chambre de dépôt sous vide. Dans le cas où la première sous-couche 170 est formée en nitrure de titane, il s'agit d'une pulvérisation cathodique réactive.

En variante, la première sous-couche peut être formée par un dépôt chimique en phase vapeur.

Puis, la deuxième sous-couche 172 de la deuxième couche 107 est déposée, de manière conforme, sur la première sous-couche 170 (étape E108b). Comme cela est visible sur la figure 13, la deuxième sous-couche 172 est formée de manière à remplir tout l'espace restant dans la cavité 150. Cela permet alors d'obtenir un dispositif de stockage ferroélectrique 100 complètement intégré dans la cavité 150 et sans saillie ou récession formée par rapport à la surface de la couche support 110. L'ensemble formé par la couche support 110 dans laquelle est intégrée le dispositif de stockage ferroélectrique 100 présente donc une surface uniforme.

En pratique, la deuxième sous-couche 172 est par exemple formée par pulvérisation cathodique dans une chambre de dépôt sous vide. En pratique, la deuxième sous-couche 172 de la deuxième couche 107 est formée dans la même chambre de dépôt que la première sous-couche 170 de la deuxième couche 107.

Dans le cas où la deuxième sous-couche 172 est formée en nitrure de titane, il s'agit d'une pulvérisation cathodique réactive.

Le dispositif de stockage ferroélectrique 100 se présente alors sous la forme d'un empilement continu de couches. En d'autres termes, le dispositif de stockage ferroélectrique 100 comprend une continuité dans les couches qui le composent.

En pratique, en bien que cela ne soit pas visible sur les figures annexées, il n'est pas exclu que les différentes couches du dispositif 100 de stockage ferroélectrique soient déposées également sur la face avant (surface libre à l'opposé de la paroi de fond 152) de la couche support. Ainsi, de manière optionnelle, afin de s'assurer de la planéité et de l'uniformité du dispositif 100 de stockage ferroélectrique (et en particulier de la surface libre du dispositif 100), il peut être prévu une étape de planarisation, après l'étape E108. Cette étape de planarisation est par exemple mise en oeuvre par polissage mécanochimique (ou CMP pour « *Chemical mechanical polishing* » selon l'acronyme d'origine anglosaxonne couramment utilisé). Tout autre méthode adaptée peut être utilisée (notamment les méthodes de masquage).

Cette étape de planarisation est particulièrement avantageuse car, grâce à l'uniformisation de la surface du dispositif 100, elle permet d'améliorer les performances électriques du dispositif de stockage ferroélectrique et de garantir une meilleure qualité des interconnexions.

En variante, une étape d'encapsulation peut être prévue après cette étape de planarisation. Enfin, un raccordement à la deuxième couche peut être mis en oeuvre.

Ainsi, à l'issue du procédé de fabrication selon ce deuxième mode de réalisation, le dispositif de stockage ferroélectrique 100 obtenu comprend une couche de matériau ferroélectrique à épaisseur variable. Comme indiqué précédemment, variabilité d'épaisseurs permet d'introduire des non-uniformités dans les propriétés ferroélectriques de la couche de matériau ferroélectrique. Cette non-uniformité des propriétés permet notamment d'augmenter les différences entre les gammes de tensions à appliquer pour encoder les informations dans les différents états de polarisation intermédiaires.

Cela permet alors d'éviter le recouvrement entre les gammes de tensions concernées et donc d'identifier sans ambiguïté les états de polarisation intermédiaires concernés par les informations encodées.

De plus, le procédé de fabrication selon ce deuxième mode de réalisation permet d'obtenir une architecture du dispositif 100 de stockage ferroélectrique en trois dimensions. Cela permet notamment d'augmenter la surface de la capacité du dispositif 100 de stockage ferroélectrique.

La figure 15 représente, sous forme de logigramme, un exemple du procédé de fabrication selon le troisième mode de réalisation.

Ce troisième mode de réalisation du procédé de fabrication est similaire au deuxième mode de réalisation décrit précédemment. Aussi, seules les différences par rapport à ce deuxième mode de réalisation sont décrites en détails dans la suite.

Comme cela est visible sur la figure 15, le procédé de fabrication comprend tout d'abord une étape E200 (similaire à l'étape E100) de fourniture d'une couche support 210.

Puis, le procédé de fabrication se poursuit à l'étape E202, lors de laquelle la cavité 250 (dans laquelle va être formé le dispositif 200 de stockage ferroélectrique) est formée. Une unique cavité 250 est formée ici. La figure 16 illustre cette étape E202.

La spécificité de ce troisième mode de réalisation réside dans la formation de la cavité 250, et plus particulièrement dans la formation de la paroi latérale 255 de la cavité 250. Ici, l'étape E202 comprend en fait deux sous-étapes : une première sous-étape E202a de formation d'une première portion 255a de la paroi latérale 255 et une deuxième sous-étape E202b de formation d'une deuxième portion 255b de la paroi latérale 255.

La première sous-étape E202a est mise en oeuvre par une gravure isotrope de manière à former la paroi de fond 252 et la première portion 255a de la paroi latérale 250. Il s'agit par exemple ici d'une gravure chimique humide.

La première portion 255a de la paroi latérale 255 de la cavité 250 est formée de telle manière à présenter le premier angle d'inclinaison α par rapport à l'axe z parallèle à une direction normale à la paroi de fond 252 (comme lors de l'étape E102 décrite précédemment).

La première portion 255a de la paroi latérale 255 forme donc un premier angle d'inclinaison α non nul par rapport à un axe z, correspondant à une direction normale à la paroi de fond 252.

La deuxième sous-étape E202b correspond à une étape de gravure isotrope supplémentaire de la cavité 255. Plus particulièrement, cette deuxième sous-étape E202b viser à former la deuxième portion 255b de la paroi latérale 255 de la cavité 250.

Ici, la deuxième portion 255b de la paroi latérale 255 de la cavité 250 est formée, sur la paroi latérale 255, au niveau de la surface opposée à la paroi de fond 252. Cette deuxième portion 255b est réalisée de telle manière qu'elle forme un deuxième angle d'inclinaison β par rapport à l'axe z parallèle à une direction normale à la paroi de fond 252. En d'autres termes, la deuxième portion 255b de la paroi latérale 255 forme donc un deuxième angle d'inclinaison β non nul par rapport à un axe z, correspondant à une direction normale à la paroi de fond 252.

Ainsi, à l'issue de l'étape E202, la paroi latérale 255 de la cavité 250 présentant une première portion 255a inclinée d'un premier angle α par rapport à l'axe z et une deuxième portion 255b inclinée d'un deuxième angle β par rapport à l'axe z est formée. Ici, cette paroi latérale 255 de la cavité 250 présente donc une rupture de pente, avec la première portion inclinée 255a inclinée selon le premier angle d'inclinaison α et la deuxième portion 255b inclinée selon le deuxième angle d'inclinaison β. La paroi latérale 255 présente en quelque sorte ici une forme en « Y ».

Comme cela est visible sur la figure 15, le procédé de fabrication se poursuit, à l'étape E204, par le dépôt de la première couche 202. La figure 17 illustre cette étape E204. L'étape E204 est similaire à l'étape E104 décrite pour le deuxième mode de réalisation.

Cette première couche 202 est déposée dans la cavité 250. Plus particulièrement, la première couche 202 est déposée le long de la paroi de fond 252 et de la paroi latérale 255 de la cavité 250.

Le dépôt de la première couche 202 est effectué ici de manière conforme.

Comme indiqué précédemment, la première couche 202 comprend ici une première sous-couche 220 et une deuxième sous-couche 222.

L'étape E204 de dépôt de la première couche 202 comprend donc ici deux sous-étapes : une première sous-étape E204a de dépôt de la première sous-couche 220 et une deuxième sous-étape E204b de dépôt de la deuxième sous-couche 222.

La première sous-couche 220 est donc tout d'abord déposée, de manière conforme, dans la cavité 250 (étape E204a). En pratique, la première sous-couche 220 est par exemple formée par pulvérisation cathodique dans une chambre de dépôt sous vide. Dans le cas où la première sous-couche 220 est formée en nitrure de titane, il s'agit d'une pulvérisation cathodique réactive.

En variante, la première sous-couche peut être formée par un dépôt chimique en phase vapeur.

Puis, la deuxième sous-couche 222 de la première couche 202 est déposée, de manière conforme, sur la première sous-couche 220 (étape E204b). La deuxième sous-couche 222 est par exemple formée par pulvérisation cathodique dans une chambre de dépôt sous vide. En pratique, la deuxième sous-couche 222 de la première couche 202 est formée dans la même chambre de dépôt que la première sous-couche 220 de la première couche 202.

Dans le cas où la deuxième sous-couche 222 est formée en nitrure de titane, il s'agit d'une pulvérisation cathodique réactive.

Puis, le procédé de fabrication se poursuit à l'étape E206 de dépôt de la couche de matériau ferroélectrique 205 sur la première couche 202. Plus particulièrement, la couche de matériau ferroélectrique 205 est déposée sur la deuxième sous-couche 222 de la première couche 202. Cette étape E206 est représentée sur la figure 18. L'étape E206 est similaire à l'étape E106 décrite précédemment pour le deuxième mode de réalisation.

De manière avantageuse dans ce deuxième mode de réalisation, le dépôt de la couche de matériau ferroélectrique 205 est mis en oeuvre de manière non conforme. Cela signifie donc que le dépôt est réalisé de telle manière que l'épaisseur de la couche de matériau ferroélectrique 205 est variable.

Plus particulièrement ici, le dépôt est mis en oeuvre de manière à obtenir une épaisseur e₂ du matériau ferroélectrique au niveau de la paroi de fond 252, à obtenir une épaisseur e₁ du matériau ferroélectrique au niveau de la première portion 255a de la paroi latérale 255 et une épaisseur e₃ au niveau de la deuxième portion 255b de la paroi latérale 255 de la cavité 250. Ici, les épaisseurs vérifient l'inégalité suivante : e₂>e₃>e₁.

En d'autres termes, la plus grande épaisseur e₂ de matériau ferroélectrique est formée au niveau de la paroi de fond 252, une épaisseur intermédiaire e₃ est formée au niveau de la deuxième portion 225b de la paroi latérale 255 de la cavité 250 et la plus faible épaisseur e₁ est formée au niveau de la première portion 255a de la paroi latérale 255 de la cavité 250.

En pratique, l'étape E206 de dépôt (non conforme) est par exemple mise en oeuvre par une méthode de dépôt physique en phase vapeur (ou PVD pour « *Physical Vapor Deposition »).*

En variante, la couche de matériau ferroélectrique peut être déposée par pulvérisation cathodique. En variante encore, la couche de matériau ferroélectrique peut être déposée par une méthode de dépôt par faisceau d'ions (ou IBD pour « *Ion Beam Deposition »).*

Ce dépôt non conforme permet de former directement la couche de matériau ferroélectrique 205 avec une première partie 205A qui présente la première épaisseur e₁ (épaisseur la plus faible), une deuxième partie 206 qui présente la deuxième épaisseur e₂ (épaisseur la plus grande) et une troisième partie 205B qui présente la troisième épaisseur e₃.

Ces différences d'épaisseurs impliquent alors qu'il sera nécessaire d'appliquer une plus forte tension pour permettre d'encoder des informations mémorisées dans l'état de polarisation intermédiaire associé à la deuxième partie 206, une tension intermédiaire pour permettre d'encoder des informations mémorisées dans l'état de polarisation intermédiaire associé à la troisième partie 205B et enfin une plus faible tension pour permettre d'encoder des informations mémorisées dans l'état de polarisation intermédiaire associé à la première partie 205A.

Le procédé se poursuit ensuite, à l'étape E208, par le dépôt de la deuxième couche 207. Cette étape E208 est représentée sur la figure 19. Cette étape est similaire à l'étape E108 décrite précédemment pour le deuxième mode de réalisation.

La deuxième couche 207 est formée sur la couche de matériau ferroélectrique 205 obtenue à l'issue de l'étape E206.

Le dépôt de la deuxième couche 207 est réalisé de manière conforme.

Comme indiqué précédemment, la deuxième couche 207 peut comprendre ici une première sous-couche 270 et une deuxième sous-couche 272.

L'étape E208 de dépôt de la deuxième couche 207 comprend donc ici deux sous-étapes : une première sous-étape E208a de dépôt de la première sous-couche 270 et une deuxième sous-étape 208b de dépôt de la deuxième sous-couche 272.

La première sous-couche 270 est donc tout d'abord déposée, de manière conforme, sur la couche de matériau ferroélectrique 205 (étape E208a). En pratique, la première sous-couche 270 est par exemple formée par pulvérisation cathodique dans une chambre de dépôt sous vide. Dans le cas où la première sous-couche 270 est formée en nitrure de titane, il s'agit d'une pulvérisation cathodique réactive.

En variante, la première sous-couche peut être formée par un dépôt chimique en phase vapeur.

Puis, la deuxième sous-couche 272 de la deuxième couche 207 est déposée, de manière conforme, sur la première sous-couche 270 (étape E208b). Comme cela est visible sur la figure 19, la deuxième sous-couche 272 est formée de manière à remplir tout l'espace restant dans la cavité 250. Cela permet alors d'obtenir un dispositif de stockage ferroélectrique 200 complètement intégré dans la cavité 250 et sans saillie ou récession formée par rapport à la surface de la couche support 210. L'ensemble formé par la couche support 210 dans laquelle est intégrée le dispositif de stockage ferroélectrique 200 présente donc une surface uniforme.

En pratique, la deuxième sous-couche 272 est par exemple formée par pulvérisation cathodique dans une chambre de dépôt sous vide. En pratique, la deuxième sous-couche 272 de la deuxième couche 207 est formée dans la même chambre de dépôt que la première sous-couche 270 de la deuxième couche 207.

Dans le cas où la deuxième sous-couche 272 est formée en nitrure de titane, il s'agit d'une pulvérisation cathodique réactive.

En pratique, en bien que cela ne soit pas visible sur les figures annexées, il n'est pas exclu que les différentes couches du dispositif 200 de stockage ferroélectrique soient déposées également sur la face avant (surface libre à l'opposé de la paroi de fond 252) de la couche support. Ainsi, de manière optionnelle, afin de s'assurer de la planéité et de l'uniformité du dispositif 200 de stockage ferroélectrique (et en particulier de la surface libre du dispositif 200), il peut être prévu une étape de planarisation, après l'étape E208. Cette étape de planarisation est par exemple mise en oeuvre par polissage mécanochimique (ou CMP pour « *Chemical mechanical polishing* » selon l'acronyme d'origine anglosaxonne couramment utilisé). Tout autre méthode adaptée peut être utilisée (notamment les méthodes de masquage).

Cette étape de planarisation est particulièrement avantageuse car, grâce à l'uniformisation de la surface du dispositif 1, elle permet d'améliorer les performances électriques du dispositif de stockage ferroélectrique et de garantir une meilleure qualité des interconnexions.

En variante, une étape d'encapsulation peut être prévue après cette étape de planarisation. Enfin, un raccordement à la deuxième couche peut être mis en oeuvre.

Le dispositif de stockage ferroélectrique 200 se présente alors sous la forme d'un empilement continu de couches. En d'autres termes, le dispositif de stockage ferroélectrique 200 comprend une continuité dans les couches qu'il comprend.

Ainsi, à l'issue du procédé de fabrication selon ce deuxième mode de réalisation, le dispositif 200 de stockage ferroélectrique obtenu comprend une couche de matériau ferroélectrique à épaisseur variable. Comme indiqué précédemment, la variabilité d'épaisseurs permet d'introduire une non-uniformité dans les propriétés ferroélectriques de la couche de matériau ferroélectrique. Cette non-uniformité des propriétés permet notamment d'augmenter les différences entre les gammes de tensions à appliquer pour mémoriser les informations dans les différents états de polarisation intermédiaires. Cela permet alors d'éviter le recouvrement entre les gammes de tensions concernées et donc d'identifier sans ambiguïté les états de polarisation intermédiaires concernés par les informations mémorisées.

De plus, le procédé de fabrication selon ce troisième mode de réalisation permet d'obtenir une architecture du dispositif 200 de stockage ferroélectrique en trois dimensions. Cela permet notamment d'augmenter la surface de la capacité du dispositif 200 de stockage ferroélectrique.

### Applications

Le dispositif de stockage ferroélectrique conforme à l'invention trouve une application privilégiée dans le cadre des mémoires résistives de type FeRAM (pour *« Ferroelectric Random Access Memory* » selon l'acronyme d'origine anglo-saxonne couramment utilisé).

Il trouve également une application particulière dans le cadre de transistors, par exemple de type FeMFET (pour « *Ferroelectric-metal field effect transistor »* selon l'acronyme d'origine anglo-saxonne couramment utilisé).

Le dispositif de stockage ferroélectrique conforme à l'invention peut également être utilisé dans le cadre de jonctions tunnel ferroélectriques (ou FTJ pour « *Ferroelectric tunnel jonction* » selon l'acronyme d'origine anglosaxonne couramment utilisé). Dans ce cas, une couche supplémentaire est ajoutée entre la couche de matériau ferroélectrique et la deuxième couche. Cette couche supplémentaire comprend un matériau diélectrique. Ce matériau diélectrique est par exemple un oxyde d'aluminium Al₂O₃.

Dans le cas de certaines applications mentionnées (par exemple les mémoires de type FeRAM ou de type FTJ), la première couche forme une première électrode (par exemple une électrode inférieure), la deuxième couche forme une deuxième électrode (par exemple une électrode supérieure) et la couche de matériau ferroélectrique forme une couche mémoire.

## Revendications

1. Dispositif (1 ; 100 ; 200) de stockage ferroélectrique comprenant une première couche (2 ; 102 ; 202), une deuxième couche (7 ; 107 ; 207) et une couche de matériau ferroélectrique (5 ; 105 ; 205) qui s'étend entre la première couche (2 ; 102 ; 202) et la deuxième couche (7 ; 107 ; 207),
la première couche (102 ; 202) présentant une épaisseur constante,
la couche de matériau ferroélectrique (5 ; 105 ; 205) comprenant une première partie (5A ; 105A ; 205A) présentant une première épaisseur (e₁) et une deuxième partie (6 ; 106 ; 206) présentant une deuxième épaisseur (e₂), la première épaisseur (e₁) et la deuxième épaisseur (e₂) étant distinctes,
le dispositif comprenant une couche support (110 ; 210) présentant une cavité (150 ; 250), la cavité (150 ; 250) comprenant une paroi de fond (152 ; 252) et une paroi latérale (155 ; 255), la paroi latérale (155 ; 255) formant un angle d'inclinaison (α ; β) par rapport à une direction normale à la paroi de fond (152 ; 252), la première couche (102 ; 202), la deuxième couche (107 ; 207) et la couche de matériau ferroélectrique (105 ; 205) étant positionnées dans la cavité (150 ; 250).

2. Dispositif (1 ; 100 ; 200) de stockage ferroélectrique selon la revendication 1, dans lequel un rapport entre la deuxième épaisseur (e₂) et la première épaisseur (e₁) est compris entre 2 et 4.

3. Dispositif de stockage ferroélectrique selon la revendication 1 ou 2, dans lequel la première épaisseur (e₁) est comprise entre 3 et 7 nanomètres et la deuxième épaisseur (e₂) est comprise entre 12 et 17 nanomètres.

4. Dispositif (1 ; 100 ; 200) de stockage ferroélectrique selon l'une quelconque des revendications 1 à 3, dans lequel la première partie (5A ; 105A ; 205A) de la couche de matériau ferroélectrique (5 ; 105 ; 205) présente une surface d'au moins 15% de la surface totale de la couche de matériau ferroélectrique (5 ; 105 ; 205).

5. Dispositif (1 ; 100 ; 200) de stockage ferroélectrique selon l'une quelconque des revendications 1 à 4, dans lequel la couche de matériau ferroélectrique (5 ; 105 ; 205) comprend du dioxyde d'hafnium ou du dioxyde d'hafnium dopé par un élément dopant ou un alliage HfₓZr₁₋ₓO₂, avec 0<x<1.

6. Dispositif (100 ; 200) de stockage ferroélectrique selon l'une quelconque des revendications 1 à 5, dans lequel la cavité (150 ; 250) présente un profil en forme de U, la première couche (102 ; 202), la deuxième couche (107 ; 207) et la couche de matériau ferroélectrique (105 ; 205) étant positionnées dans la cavité (150 ; 250) de sorte que la première couche (102 ; 202), la deuxième couche (107 ; 207) et la couche de matériau ferroélectrique (105 ; 205) présentent un profil de forme similaire à la cavité (150 ; 250) avec un profil en forme de U.

7. Dispositif (100 ; 200) de stockage ferroélectrique selon la revendication 6, dans lequel la deuxième partie (106 ; 206) de la couche de matériau ferroélectrique (105 ; 205) est positionnée sur la paroi de fond (152 ; 252) de la cavité (150 ; 250) avec un profil en forme de U et la première partie (105A ; 205A) de la couche de matériau ferroélectrique (105 ; 205) est positionnée sur la paroi latérale (155 ; 255) de la cavité (150 ; 250) avec un profil en forme de U.

8. Dispositif (200) de stockage ferroélectrique selon l'une quelconque des revendications 1 à 7, dans lequel la paroi latérale (255) de la cavité (250) comprend une première portion (255a) et une deuxième portion (255b), la première portion (255a) formant ledit premier angle d'inclinaison (α) par rapport à la direction normale à la paroi de fond (252), la deuxième portion (255b) formant un deuxième angle d'inclinaison (β) par rapport à la direction normale à la paroi de fond (252),
la couche de matériau ferroélectrique (205) comprend une troisième partie (250B) présentant une troisième épaisseur (e₃), la troisième épaisseur (e₃) étant distincte de la première épaisseur (e₁) et de la deuxième épaisseur (e₂), la deuxième partie (206) de la couche de matériau ferroélectrique (205) étant positionnée sur la paroi de fond (252) de la cavité (250), la première partie (205A) de la couche de matériau ferroélectrique (205) étant positionnée sur la première portion (255a) de la paroi latérale (255) de la cavité (250) et la troisième partie (250B) de la couche de matériau ferroélectrique (205) étant positionnée sur la deuxième portion (255b) de la paroi latérale (255) de la cavité (250).

9. Dispositif (200) de stockage ferroélectrique selon la revendication 8, dans lequel le deuxième angle d'inclinaison (β) est supérieur audit premier angle d'inclinaison (α).

10. Dispositif (100 ; 200) de stockage ferroélectrique selon l'une quelconque des revendications 1 à 9, dans lequel la surface de contact entre la première couche (102 ; 202) et la couche de matériau ferroélectrique (105 ; 205) est parallèle à la surface de contact entre la première couche (102 ; 202) et la cavité (150 ; 250).

11. Dispositif (100 ; 200) de stockage ferroélectrique selon l'une quelconque des revendications 1 à 10, dans lequel la première couche (2 ; 102 ; 202) forme une première électrode, la deuxième couche (7 ; 107 ; 207) forme une deuxième électrode et la couche de matériau ferroélectrique (5 ; 105 ; 205) forme une couche mémoire.

12. Procédé de fabrication d'un dispositif (1 ; 100 ; 200) de stockage ferroélectrique comprenant des étapes de :
- fourniture d'une couche support (110 ; 210),
- formation d'une cavité (150 ; 250) dans la couche support (110 ; 210), la cavité (150 ; 250) comprenant une paroi de fond (152 ; 252) et une paroi latérale (155 ; 255), la paroi latérale (155 ; 255) formant un premier angle d'inclinaison (α, β) non nul par rapport à une direction normale à la paroi de fond (152 ; 252),
- dépôt d'une première couche (2 ; 102 ; 202), la première couche (2 ; 102 ; 202) présentant une épaisseur constante ;
- dépôt d'une couche de matériau ferroélectrique (5 ; 105 ; 205), la couche de matériau ferroélectrique (5 ; 105 ; 205) comprenant une première partie (5A ; 105A ; 205A) présentant une première épaisseur (e₁) et une deuxième partie (6 ; 106 ; 206) présentant une deuxième épaisseur (e₂), la première épaisseur (e₁) et la deuxième épaisseur (e₂) étant distinctes, et
- dépôt d'une deuxième couche (7 ; 107 ; 207), la couche de matériau ferroélectrique (5 ; 105 ; 205) s'étendant entre la première couche (2 ; 102 ; 202) et la deuxième couche (7 ; 107 ; 207),
le dépôt de la première couche (102 ; 202), de la couche de matériau ferroélectrique (105 ; 205) et de la deuxième couche (107 ; 207) étant mis en oeuvre dans la cavité (150 ; 250) formée,
la deuxième partie (106 ; 206) de la couche de matériau ferroélectrique (105 ; 205) étant positionnée sur la paroi de fond (152 ; 252) de la cavité (150 ; 250) et la première partie (105A ; 205A) de la couche de matériau ferroélectrique (105; 205) étant positionnée sur la paroi latérale (155 ; 255) de la cavité (150 ; 250).

13. Procédé de fabrication selon la revendication 12, dans lequel la paroi latérale (255) de la cavité (250) comprend une première portion (255a) et une deuxième portion (255b), la première portion (255a) formant ledit premier angle d'inclinaison (α) par rapport à la direction normale à la paroi de fond (252), la deuxième portion (255b) formant un deuxième angle d'inclinaison (β) par rapport à la direction normale à la paroi de fond (252),
la couche de matériau ferroélectrique (205) comprenant une troisième partie (250B) présentant une troisième épaisseur (e₃), la troisième épaisseur (e₃) étant distincte de la première épaisseur (e₁) et de la deuxième épaisseur (e₂), la deuxième partie (206) de la couche de matériau ferroélectrique (205) étant positionnée sur la paroi de fond (252) de la cavité (250), la première partie (205A) de la couche de matériau ferroélectrique (205) étant positionnée sur la première portion (255a) de la paroi latérale (255) de la cavité (250) et la troisième partie (250B) de la couche de matériau ferroélectrique (205) étant positionnée sur la deuxième portion (255b) de la paroi latérale (255) de la cavité (250).

14. Procédé de fabrication selon la revendication 12, dans lequel il est prévu, avant l'étape de dépôt de la deuxième couche (7), une étape de retrait d'une portion de la couche de matériau ferroélectrique (5), la première partie (5A) de la couche de matériau ferroélectrique (5) étant formée au niveau d'une portion restante associée à ladite portion retirée.

15. Procédé de fabrication selon l'une quelconque des revendications 12 à 14, dans lequel le dépôt de la couche de matériau ferroélectrique (5 ; 105 ; 205) est mis en oeuvre de manière conforme.
